# EUROPÄISCHE PATENTSCHRIFT

(11) **EP 0 845 055 B1**
(45) Veröffentlichungstag und Bekanntmachung des Hinweises auf die Patenterteilung: **05.09.2001**
(21) Anmeldenummer: 96920724.0
(22) Anmeldetag: 27.06.1996
(51) Int. Cl.: C30B 25/18, C30B 25/02

(54) **KEIMKRISTALL ZUM HERSTELLEN VON EINKRISTALLEN, VERWENDUNG DES KEIMKRISTALLS UND VERFAHREN ZUM HERSTELLEN VON SiC-EINKRISTALLEN ODER EINKRISTALLINEN SiC-SCHICHTEN**
SEED CRYSTAL FOR GROWING MONOCRYSTALS, USE OF THE SEED CRYSTAL AND PROCESS FOR PRODUCING SiC MONOCRYSTALS OR MONOCRYSTALLINE SiC LAYERS
GERME CRISTALLIN POUR REALISER DES MONOCRISTAUX, UTILISATION DE CE GERME CRISTALLIN ET PROCEDE POUR REALISER DES MONOCRISTAUX DE SiC OU DES COUCHES DE SiC MONOCRISTALLINES

(30) Priorität: 16.08.1995 DE 19530119
(43) Veröffentlichungstag der Anmeldung: 03.06.1998
(73) Patentinhaber: SIEMENS AKTIENGESELLSCHAFT, 80333 München (DE)
(72) Erfinder: VÖLKL, Johannes, D-91056 Erlangen (DE); STEIN, René, D-91341 Röttenbach (DE)
(74) Vertreter: Epping, Wilhelm, Dipl.-Ing.
(86) Internationale Anmeldenummer: DE9601152
(87) Internationale Veröffentlichungsnummer: WO9707265

(56) Entgegenhaltungen:
- WO-A-95/10410
- DE-A- 3 620 329
- US-A- 4 614 672
- MATERIALS SCIENCE AND ENGINEERING B, Bd. B11, Nr. 1 / 04, 15.Januar 1992, Seiten 125-129, XP000361981 PAZIK J C ET AL: "CHEMICAL VAPOR DEPOSITION OF -SIC ON SILICON-ON-SAPPHIRE AND SILICON-ON-INSULATOR SUBSTRATES"
- PATENT ABSTRACTS OF JAPAN vol. 95, no. 010 & JP,A,07 257993 (SUMITOMO ELECTRIC IND LTD), 9.Oktober 1995,

## Beschreibung

Keimkristall zum Herstellen von Einkristallen, Verwendung des Keimkristalls und Verfahren zum Herstellen von SiC-Einkristallen oder einkristallinen SiC-Schichten

Die Erfindung betrifft einen Keimkristall zum Herstellen von Einkristallen und ein Verfahren zum Herstellen von Siliciumcarbid-Einkristallen oder einkristallinen Siliciumcarbid-Schichten.

Zum Züchten von Siliciumcarbid (SiC)-Einkristallen sind Sublimationsprozesse bekannt, bei denen ein Vorrat aus festem SiC bei Temperaturen von im allgemeinen über 2000°C sublimiert wird und aus dem sublimierten SiC in der Gasphase bei Kristallisationstemperaturen von im allgemeinen zwischen 1600°C und 2500°C auf einem Keimkristall aus SiC ein SiC-Einkristall aufgewachsen wird. Die Sublimationstemperaturen am Vorrat liegt dabei höher als die Wachstumstemperaturen am Keimkristall. Ein Problem bei der Sublimationszüchtung von SiC ist die Kristallqualität der damit hergestellten SiC-Einkristalle. Insbesondere verschlechtern rohrenförmige Kristalldefekte, sogenannte "micropipes" oder "pinholes", die elektronischen Eigenschaften der gezüchteten SiC-Einkristalle. Die Problematik dieser Kristalldefekte ist beispielsweise in *Physica B, Band 185, 1993, North-Holland, Elsevier Science Publishers, Seiten 211 bis 216* beschrieben.

Aus der *WO 95/10410 A1* ist ein Verfahren zur Herstellung einer epitaxialen Schicht auf einem Substrat bekannt. Das Substrat umfaßt dabei mehrere aufeinander angeordnete Schichten. Insbesondere ist eine Oberflächenschicht auf einer Glas- oder Metallschicht angeordnet. Als Material für die Oberflächenschicht werden Galliumarsenid (GaAs) oder Indiumgalliumphosphid (InGaP) genannt. Die Glasschicht besteht aus Corning 7056 Glas oder aus Schott 283 Glas. Von besonderer Bedeutung für die Glasschicht ist dabei eine bei der Epitaxie-Wachstumstemperatur vorliegende plastische Deformierbarkeit. Durch diese Deformierbarkeit werden Fehlanpassungen zwischen Gitterkonstanten unterschiedlicher Schichten ausgeglichen, so daß auch die mechanischen Spannungen zwischen diesen Schichten reduziert werden.

Der Erfindung liegt nun die Aufgabe zugrunde, einen besonderen Keimkristall für die Herstellung von Einkristallen durch Auskristallisation aus einer Gasphase anzugeben, mit dem Kristalldefekte im aufwachsenden Einkristall verringert werden können. Der Keimkristall soll insbesondere zum Züchten von SiC-Einkristallen in einem Sublimationsprozeß oder zum Herstellen einkristalliner SiC-Schichten durch CVD verwendet werden können. Ferner sollen ein Verfahren zum Herstellen von SiC-Einkristallen und ein Verfahren zum Herstellen von einkristallinen SiC-Schichten angegeben werden.

Diese Aufgabe wird gemäß der Erfindung gelöst mit den Merkmalen des Anspruchs 1 bzw. des Anspruchs 18 bzw. des Anspruchs 19.

Der Keimkristall zum Herstellen von Einkristallen hat eine Oberfläche, die
a) in einem ersten Teilbereich als Kristallisationsfläche zum Aufwachsen eines Einkristalls aus einer Gasphase bei einer Wachstumstemperatur von mindestens 1000°C vorgesehen ist und
b) wenigstens in einem zweiten Teilbereich mit einer Beschichtung versehen ist, die aus einem gegenüber dem Material des Keimkristalls und gegenüber der Gasphase im wesentlichen chemisch resistenten Material mit einem oberhalb der Wachstumstemperatur an der Kristallisationsfläche liegenden Schmelzpunkt besteht.

Durch die Verwendung des besonderen Keimkristalls werden Pinhole-Defekte im auf dem Keimkristall aufwachsenden Einkristall reduziert.

Die Erfindung beruht auf der Erkenntnis, daß sich die Qualität eines bei vorgegebenen Wachstumstemperaturen auf einem Keimkristall aufwachsenden Einkristalls durch thermische Zersetzung (Degradation) des Keimkristalls an seiner nicht als Kristallisationsfläche dienenden freien Oberfläche verschlechtern kann. Eine solche Degradation ist insbesondere problematisch bei Keimkristallen, die aus inkongruent sublimierenden oder verdampfenden Verbindungen bestehen. Darunter versteht man Verbindungen aus wenigstens zwei Komponenten, bei denen eine Komponente bei der gleichen Temperatur einen höheren Dampfdruck aufweist als die andere, so daß das stöchiometrische Verhältnis der Komponenten im Keimkristall gestört wird. Auch Diffusionsprozesse mit unterschiedlichen Diffusionsraten für unterschiedliche Komponenten oder Inhomo genitäten im Keimkristall können thermische Zersetzungserscheinungen begünstigen. Die meist lokalen Degradationen beginnen an den Teilbereichen der Oberfläche, die nicht wie die Kristallisationsfläche vom aufwachsenden Einkristall bedeckt sind, und können sich im Verlauf eines Züchtungsprozesses in das Kristallinnere des Keimkristalls fortsetzen. Dadurch kann der Keimkristall für weitere Kristallzüchtungsprozesse unbrauchbar werden oder die Kristalldefekte im Keimkristall können sich auf die aufwachsenden Einkristalle in einem laufenden oder einem folgenden Züchtungsprozeß übertragen.

Durch die Beschichtung eines außerhalb der Kristallisationsfläche liegenden Teilbereichs der Oberfläche des Keimkristalls gemäß der Erfindung werden Degradationen im Keimkristall von seiner Oberfläche stark verringert. Die Beschichtung besteht aus einem oder mehreren Materialien, die chemisch stabil gegenüber dem Material des Keimkristalls und der wenigstens einen Substanz in der Gasphase sind sowie bei den verwendeten Wachstumstemperaturen nicht schmelzen oder wegsublimieren. Dadurch kann der Keimkristall bei praktisch gleichbleibender Qualität für mehrere, beispielsweise fünf bis zehn, Züchtungsprozesse hintereinander verwendet werden (Wiederverwendbarkeit).

Vorteilhafte Ausführungsformen des Keimkristalls ergeben sich aus den vom Anspruch 1 abhängigen Ansprüchen.

Demnach besteht der Keimkristall in einer ersten Ausführungsform aus SiC und ist zum Herstellen von Siliciumcarbid-Einkristallen, vorzugsweise aus α-SiC wie 4H-SiC oder 6H-SiC, in einem Sublimationsprozeß oder von einkristallinen SiC-Schichten, vorzugsweise aus α-SiC wie 4H-SiC oder 6H-SiC, durch einen CVD-Prozeß vorgesehen.

Der Keimkristall ist vorzugsweise wenigstens 0,5 mm dick und damit selbsttragend im Gegensatz zu einer Epitaxieschicht.

Die Beschichtung für den zweiten Teilbereich der Oberfläche besteht vorzugsweise wenigstens teilweise aus einem Metall und/oder einer metallischen Verbindung. Vorzugsweise werden Tantal (Ta) und/oder Molybdän (Mo) und/oder Tantalverbindungen und/oder Molybdänverbindungen verwendet. Als Metallverbindungen können Metallsilicide, Metallcarbide oder auch Metallnitride verwendet werden.

Die Beschichtung für den zweiten Teilbereich der Oberfläche des Keimkristalls kann aber auch wenigstens teilweise aus Kohlenstoff bestehen, vorzugsweise aus Graphit.

In einer besonderen Ausführungsform umfaßt die Beschichtung für den zweiten Teilbereich der Oberfläche mehrere, aufeinander angeordnete Schichten, die aus gleichen oder verschiedenen Materialien bestehen können.

Vorzugsweise ist die Beschichtung nicht dicker als etwa 100 µm. Bevorzugte Dicken der Beschichtung liegen zwischen etwa 0,5 µm und etwa 100 µm.

Der beschichtete zweite Teilbereich der Oberfläche des Keimkristalls ist vorzugsweise auf einer von dem als Kristallisationsfläche dienenden ersten Teilbereich abgewandten Seite der Oberfläche des Keimkristalls angeordnet.

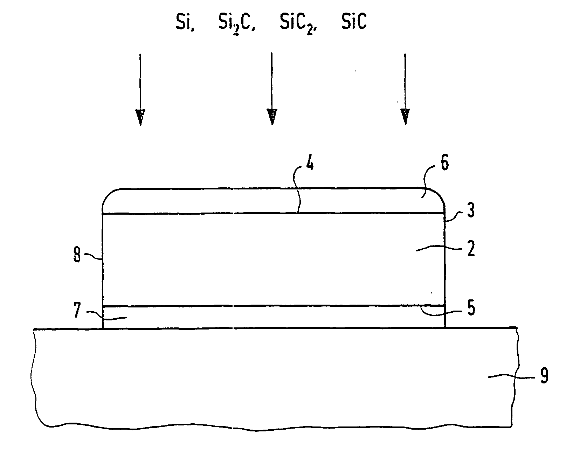

Zur weiteren Erläuterung der Erfindung wird auf die Zeichnung Bezug genommen, in deren einziger Figur ein Ausführungsbeispiel eines Keimkristalls für die Züchtung von SiC-Einkristallen schematisch dargestellt ist.

Es sind ein Keimkristall mit 2, seine Oberfläche mit 3, ein erster Teilbereich dieser Oberfläche 3 mit 4, ein zweiter Teilbereich der Oberfläche 3 mit 5, ein dritter Teilbereich der Oberfläche 3 mit 8, ein SiC-Einkristall mit 6, eine Beschichtung mit 7 und ein Keimhalter mit 9 bezeichnet.

Der Keimkristall 2 besteht vorzugsweise aus einkristallinem SiC eines vorgegebenen Polytyps, insbesondere des 3C-, 4H- oder 6H-Polytyps. Der erste Teilbereich 4 der Oberfläche 3 des Keimkristalls 2 ist als Kristallisationsfläche zum Auskristallisieren (Kondensieren) des SiC-Einkristalls 6 aus SiC in der Gasphase vorgesehen. Der als Kristallisationsfläche vorgesehene erste Teilbereich 4 kann insbesondere mit einer der beiden polaren Seiten (basal planes), also einer Siliciumseite oder einer Kohlenstoffseite, des SiC-Keimkristalls 2 gebildet sein. Der Kristallisationsfläche 4 wird SiC in der Gasphase zugeführt, das vorzugsweise durch Sublimieren von festem SiC aus einem nicht dargestellten SiC-Vorrat erzeugt wird. Sublimiertes SiC in der Gasphase besteht im allgemeinen aus den Komponenten Si, Si₂C und SiC₂ sowie SiC selbst in gasförmigem Zustand. Auf der Kristallisationsfläche 4 wächst bei vorgegebenen Wachstumstemperaturen (Kristallisationstemperaturen) aus dem SiC in der Gasphase der SiC-Einkristall 6 auf dem Keimkristall 2 auf. Typische Wachstumstemperaturen an der Kristallisationsfläche 4 liegen zwischen etwa 1600°C und etwa 2500°C.

Der Keimkristall 2 kann insbesondere scheibenförmig sein und ist im allgemeinen auf dem Keimhalter 9 angeordnet. Der Keimhalter 9 kann beispielsweise aus Graphit bestehen. Der Keimkristall 2 kann insbesondere in einem oberen Teil eines nicht dargestellten Reaktionsgefäßes angeordnet werden und der SiC-Vorrat in einem unteren Teil dieses Reaktionsgefäßes. Der Keimkristall 2 wird insbesondere in dieser Ausführungsform dann vorzugsweise an dem Keimhalter 9 befestigt, beispielsweise mechanisch oder mit Hilfe einer Zuckerlösung als "Kleber". Wenn der Keimkristall 2 in einem unteren Teil des Reaktionsgefäßes angeordnet wird, kann der Keimkristall 2 auch nur auf dem Keimhalter 9 aufliegen. Der dem Keimhalter 9 zugewandte zweite Teilbereich 5 der Oberfläche 3 des Keimkristalls 2 und der als Kristallisationsfläche vorgesehene erste Teilbereich 4 der Oberfläche 3 liegen vorzugsweise auf entgegengesetzten Seiten des Keimkristalls 2. Die den ersten Teilbereich 4 und den zweiten Teilbereich 5 verbindenden Seitenflächen des Keimkristalls 2 bilden den dritten Teilbereich 8 der Oberfläche 3 des Keimkristalls 2.

An dem nicht dargestellten SiC-Vorrat wird zum Sublimieren (Verdampfen) von SiC eine Sublimationstemperatur eingestellt, die vorzugsweise höher ist als die Kristallisationstemperatur an der Kristallisationsfläche 4 des Keimkristalls 2 und im allgemeinen zwischen 2000°C und 2600°C liegt. Zwischen dem SiC-Vorrat und dem Keimkristall 2 stellt sich ein Temperaturgradient ein, der in seinem Verlauf durch zusätzliche thermische Isolationen und/oder Heizeinrichtungen und/oder die geometrische Anordnung des Keimkristalls 2 und des SiC-Vorrats zueinander zusätzlich eingestellt werden kann. Der Temperaturgradient zwischen SiC-Vorrat und dem ersten Teilbereich 4 des Keimkristalls 2 hat zur Folge, daß sich auch zwischen dem Keimkristall 2 und dem Keimhalter 9 ein Temperaturgradient einstellt, aufgrund dessen Silicium aus dem SiC des Keimkristalls 2 entweichen kann.

Die Oberfläche 3 des Keimkristalls 2 ist deshalb in dem dem Keimhalter 9 zugewandten zweiten Teilbereich 5 mit der Beschichtung 7 versehen, so daß zwischen dem zweiten Teilbereich 5 der Oberfläche 3 des Keimkristalls 2 und dem Keimhalter 9 die Beschichtung 7 zu liegen kommt. Die Beschichtung 7 versiegelt den von ihr bedeckten zweiten Teilbereich 5 der Oberfläche 3 des Keimkristalls 2 und verhindert das Entweichen von Substanzen aus dem Keimkristall 2 aufgrund der hohen Temperaturen am zweiten Teilbereich 5 der Oberfläche 3 und die damit verbundene Degradation des Keimkristalls 2. Insbesondere werden durch die Beschichtung 7 verhindert:
1. die Sublimation von Silicium (Si) aus dem SiC in das Reaktionsgefäß, beispielsweise durch Poren im Keimhalter 9 oder durch insbesondere bei einer vorausgegangenen mechanischen Bearbeitung entstandene Zwischenräume zwischen dem Keimkristall 2 und dem Keimhalter 9,
2. die Diffusion insbesondere von Silicium aus dem Keimkristall 2 in den Keimhalter 9 und auch
3. eine chemische Reaktion des Siliciums aus dem SiC des Keimkristalls 2 mit dem Material (z.B. Graphit) des Keimhalters 9.

Für die Beschichtung 7 werden dazu ein oder mehrere bei den verwendeten Wachstumstemperaturen nicht verdampfende Materialien verwendet, die chemisch nicht mit dem SiC des Keimkristalls 2 und auch nicht mit dem SiC in der Gasphase im Reaktionsgefäß reagieren. Geringfügige Änderungen der Zusammensetzung oder eine kristallographische Modifikationsänderung der Beschichtung 7 während des Sublimationsprozesses sind zulässig, solange die genannten Eigenschaften der Beschichtung 7 erhalten bleiben.

Wenn die Beschichtung 7 wie dargestellt mit einem Keimhalter 9 in Berührung steht, sollte die Beschichtung 7 auch chemisch resistent gegen das Material des Keimhalters 9 sein.

Geeignete Materialien für die Beschichtung 7 sind beispielsweise hochschmelzende Metalle wie Wolfram (W), Tantal (Ta) oder Molybdän (Mo) und Verbindungen dieser Metalle untereinander, beispielsweise Legierungen, sowie mit anderen chemischen Elementen. Bevorzugte Metallverbindungen sind Metallsilicide, Metallcarbide und Metallnitride. Als Metallcarbid kann insbesondere Tantalcarbid, beispielsweise TaC oder Ta₂C, oder Molybdäncarbid, beispielsweise MoC, Mo₂C, Mo₃C₂ oder Mo₅C₅, verwendet werden. Als Metallnitrid eignet sich insbesondere Tantalnitrid TaN oder Ta₂N. Außerdem können auch Metalloxide verwendet werden.

Ferner kann die Beschichtung 7 auch wenigstens teilweise aus elementarem Kohlenstoff (C) verschiedener Modifikationen vorzugsweise mit hoher Dichte bestehen, insbesondere aus Graphit (Pyrographit).

Die Beschichtung 7 kann durch Aufschmelzen, thermisches Aufdampfen im Vakuum, chemische Dampfabscheidung (CVD), Elektronenstrahlverdampfen, Reaktionssintern, Laserablation, Plasmabeschichten oder auch durch Aufsputtern auf den zweiten Teilbereich 5 der Oberfläche 3 des Keimkristalls 2 aufgebracht werden.

In einer vorteilhaften Ausführungsform umfaßt die Beschichtung 7 mehrere einzelne Schichten (Lagen), die übereinander angeordnet sind. Für eine solche Mehrlagenbeschichtung können dabei unterschiedliche Materialien vorgesehen sein, die sandwichartig übereinander geschichtet werden. Bei einer Mehrlagenbeschichtung ist es vorteilhaft, wenn die unmittelbar auf der Oberfläche 3 des Keimkristalls 2 angeordnete, innerste Schicht einen größeren Gehalt an Kohlenstoff (C) als an Silicium (Si) aufweist, um einen Siliciumtransport aus dem Keimkristall 2 zu verhindern.

Aufgrund der Beschichtung 7 können zwischen Keimkristall 2 und dem Keimhalter 9 auch größere Zwischenräume sein. Die Anforderungen an die mechanische Bearbeitungsqualität sind deshalb geringer als bei einem genau an den Keimhalter 9 anzupassenden Keimkristall 2 ohne Beschichtung 7. In einer besonderen, nicht dargestellten Ausführungsform liegt der Keimkristall 2 nicht mehr auf einem Keimhalter 9 auf, sondern wird freitragend in dem Reaktionsgefäß angeordnet.

In einer weiteren nicht dargestellten Ausführungsform ist außer dem zweiten Teilbereich 4 auch der dritte Teilbereich 8 der Oberfläche 3 des Keimkristalls 2 mit einer Beschichtung versehen. In der dargestellten Ausführungsform kann dies insbesondere dadurch erreicht werden, daß man die Beschichtung 7 auch über die seitlichen Flächen des Keimkristalls 2 fortsetzt, so daß die Oberfläche 3 der Keimkristall 2 außerhalb der Kristallisationfläche 4 praktisch vollständig beschichtet (versiegelt) ist.

Obwohl der Keimkristall gemäß der Erfindung anhand eines Ausführungsbeispiels für einen SiC-Sublimationsprozeß beschrieben wurde, kann ein gemäß der Erfindung beschichteter Keimkristall für alle Kristallzüchtungsprozesse eingesetzt werden, bei denen aufgrund der hohen Wachstumstemperaturen am Keimkristall eine thermische Degradation des Keimkristalls stattfinden kann, insbesondere auch in einem CVD-Prozeß zum Herstellen von einkristallinen SiC-Schichten (CVD = Chemical Vapour Deposition = chemische Dampfphasenabscheidung). Bei einem CVD-Prozeß werden Arbeitsgase zum Zuführen von Silicium (Si) und Kohlenstoff (C) und im allgemeinen ein Trägergas, vorzugsweise Wasserstoff (H₂), auf die Kristallisationsoberfläche des Keimkristalls geleitet. Durch chemische Reaktionen scheidet sich auf dem Keimkristall bei Temperaturen von typischerweise zwischen etwa 1000°C und etwa 2500°C einkristallines SiC ab.

## Patentansprüche

1. Keimkristall (2) zum Herstellen von Einkristallen mit einer Oberfläche (3), die
a) in einem ersten Teilbereich (4) als Kristallisationsfläche zum Aufwachsen eines Einkristalls (6) aus einer Gasphase bei einer Wachstumstemperatur von mindestens 1000°C vorgesehen ist und
b) wenigstens in einem zweiten Teilbereich (5) mit einer Beschichtung (7) versehen ist, die aus einem gegenüber dem Material des Keimkristalls (2) und gegenüber der Gasphase im wesentlichen chemisch resistenten Material mit einem oberhalb der Wachstumstemperatur liegenden Schmelzpunkt besteht.

2. Keimkristall nach Anspruch 1 aus Siliciumcarbid.

3. Keimkristall nach Anspruch 1 oder Anspruch 2, bei dem die Beschichtung (7) für den zweiten Teilbereich (5) der Oberfläche (3) im wesentlichen aus einem Metall und/oder einer metallischen Verbindung besteht.

4. Keimkristall nach Anspruch 3, bei dem die Beschichtung (7) für den zweiten Teilbereich (5) der Oberfläche (3) wenigstens teilweise aus einem Metallsilicid besteht.

5. Keimkristall nach Anspruch 3 oder Anspruch 4, bei dem die Beschichtung (7) für den zweiten Teilbereich (5) der Oberfläche (3) wenigstens teilweise aus einem Metallcarbid besteht.

6. Keimkristall nach einem der Ansprüche 3 bis 5, bei dem die Beschichtung (7) für den zweiten Teilbereich (5) der Oberfläche (3) wenigstens teilweise aus einem Metallnitrid besteht.

7. Keimkristall nach einem der Ansprüche 3 bis 6, bei dem die Beschichtung (7) für den zweiten Teilbereich (5) der Oberfläche (3) wenigstens teilweise aus Tantal (Ta) und/oder einer Tantalverbindung besteht.

8. Keimkristall nach einem der Ansprüche 3 bis 7, bei dem die Beschichtung (7) für den zweiten Teilbereich (5) der Oberfläche (3) wenigstens teilweise aus Molybdän (Mo) und/oder einer Molybdänverbindung besteht.

9. Keimkristall nach einem der vorhergehenden Ansprüche, bei dem die Beschichtung (7) für den zweiten Teilbereich (5) der Oberfläche (3) wenigstens teilweise aus Kohlenstoff besteht.

10. Keimkristall nach Anspruch 9, bei dem die Beschichtung (7) für den zweiten Teilbereich (5) der Oberfläche (3) wenigstens teilweise aus Graphit besteht.

11. Keimkristall nach einem der vorhergehenden Ansprüche, bei dem die Beschichtung (7) für den zweiten Teilbereich (5) der Oberfläche (3) mehrere, aufeinander angeordnete Schichten umfaßt.

12. Keimkristall nach einem der vorhergehenden Ansprüche, bei dem der zweite Teilbereich (5) der Oberfläche (3) auf einer von dem ersten Teilbereich (4) abgewandten Seite der Oberfläche (3) angeordnet ist.

13. Keimkristall nach einem der vorhergehenden Ansprüche, bei dem die Beschichtung (7) höchstens etwa 100 µm dick ist.

14. Keimkristall nach einem der vorhergehenden Ansprüche, bei dem die Beschichtung (7) höchstens etwa 10 µm dick ist.

15. Keimkristall nach einem der vorhergehenden Ansprüche mit einer senkrecht zur Kristallisationsfläche gemessenen Dicke von wenigstens 0,5 mm.

16. Verwendung eines Keimkristalls nach einem der vorhergehenden Ansprüche zum Herstellen von Siliciumcarbid-Einkristallen in einem Sublimationsprozeß.

17. Verwendung eines Keimkristalls nach einem der Ansprüche 1 bis 15 zum Herstellen von Siliciumcarbid-Einkristallen durch chemische Gasphasenabscheidung (CVD).

18. Verfahren zum Herstellen von Siliciumcarbid-Einkristallen, bei dem
a) Siliciumcarbid (SiC) in fester Form wenigstens teilweise sublimiert wird und
b) aus dem sublimierten SiC in der Gasphase auf einem ersten, als Kristallisationsfläche vorgesehenen Teilbereich (4) der Oberfläche (3) eines Keimkristalls (2) ein SiC-Einkristall (6) bei wenigstens einer vorgegebenen Wachstumstemperatur aufgewachsen wird, wobei
c) ein Keimkristall (2) gemäß einem der Ansprüche 1 bis 15 verwendet wird.

19. Verfahren zum Herstellen einer einkristallinen Siliciumcarbidschicht durch chemisches Abscheiden aus der Gasphase (CVD), bei dem ein Keimkristall (2) nach einem der Ansprüche 1 bis 15 als Substrat zum Abscheiden der Siliciumcarbidschicht verwendet wird.

## Claims

1. Seed crystal (2) for production of monocrystals with a surface (3) which
a) is provided in a first portion (4) as crystallisation surface for growing a monocrystal (6) from a gas phase at a growth temperature of at least 1000°C and
b) is provided at least in a second portion (5) with a coating (7) which is composed of a material which is essentially chemically resistant with respect to the material of the seed crystal (2) and with respect to the gas phase and with a melting point which lies above the growth temperature.

2. Seed crystal according to Claim 1 of silicon carbide.

3. Seed crystal according to Claim 1 or Claim 2 in which the coating (7) for the second portion (5) of the surface (3) essentially consists of a metal and/or a metallic compound.

4. Seed crystal according to Claim 3 in which the coating (7) for the second portion (5) of the surface (3) consists at least partially of a metal silicide.

5. Seed crystal according to Claim 3 or Claim 4 in which the coating (7) for the second portion (5) of the surface (3) consists at least partially of a metal carbide.

6. Seed crystal according to one of Claims 3 to 5 in which the coating (7) for the second portion (5) of surface (3) consists at least partially of a metal nitride.

7. Seed crystal according to one of Claims 3 to 6 in which the coating (7) for the second portion (5) of surface (3) consists at least partially of tantalum (Ta) and/or of a tantalum compound.

8. Seed crystal according to one of Claims 3 to 7 in which the coating (7) for the second portion (5) of surface (3) consists at least partially of molybdenum (Mo) and/or of a molybdenum compound.

9. Seed crystal according to one of the preceding claims in which the coating (7) for the second portion (5) of surface (3) consists at least partially of carbon.

10. Seed crystal according to Claim 9 in which the coating (7) for the second portion (5) of surface (3) consists at least partially of graphite.

11. Seed crystal according to one of the preceding claims in which the coating (7) for the second portion (5) of surface (3) comprises several layers arranged one on top of the other.

12. Seed crystal according to one of the preceding claims in which the second portion (5) of surface (3) is arranged on a side of the surface (3) turned away from the first portion (4).

13. Seed crystal according to one of the preceding claims in which the coating (7) is a maximum of around 100 µm thick.

14. Seed crystal according to one of the preceding claims in which the coating (7) is a maximum of around 10 µm thick.

15. Seed crystal according to one of the preceding claims with a thickness measured perpendicular to the crystallisation surface of at least 0.5 mm.

16. Use of a seed crystal according to one of the preceding claims for the production of silicon carbide monocrystals in a sublimation process.

17. Use of a seed crystal according to one of Claims 1 to 15 for the production of silicon carbide monocrystals in a chemical gas phase deposition process (CVD).

18. Method for producing silicon carbide monocrystals in which
a) silicon carbide (SiC) in solid form is at least partially sublimated and
b) from the sublimated SiC in the gas phase on a first portion (4) of the surface (3) of a seed crystal (2) which is provided as crystallisation surface, an SiC monocrystal (6) is grown with at least a specified growth temperature, with
c) a seed crystal (2) according to one of Claims 1 to 15 being used.

19. Method for producing a monocrystalline silicon carbide layer through chemical deposition from the gas phase (CVD) in which a seed crystal (2) according to one of Claims 1 to 15 is used as substrate for deposition of the silicon carbide layer.

## Revendications

1. Cristal (2) germe pour préparer des monocristaux ayant une surface (3) qui
a) est prévue dans une première sous-région (4) en tant que surface de cristallisation pour la croissance d'un monocristal (6) en phase gazeuse à une température de croissance d'au moins 1000°C et
b) est munie dans au moins une deuxième sous-région (5) d'un revêtement (7) qui est en une matière résistant sensiblement du point de vue chimique par rapport à la matière du cristal (2) germe et par rapport à la phase gazeuse et ayant un point de fusion supérieur à la température à laquelle s'effectue la croissance.

2. Cristal germe suivant la revendication 1 en carbure de silicium

3. Cristal germe suivant la revendication 1 ou la revendication 2, dans lequel le revêtement (7) de la deuxième sous-région (5) de la surface (3) est constitué essentiellement d'un métal et/ou d'un composé métallique.

4. Cristal germe suivant la revendication 3, dans lequel le revêtement (7) de la deuxième sous-région (5) de la surface (3) est constitué au moins partiellement d'un silicium métallique.

5. Cristal germe suivant la revendication 3 ou la revendication 4, dans lequel le revêtement (7) de la deuxième sous-région (5) de la surface (3) est constitué au moins en partie d'un carbure métallique.

6. Cristal germe suivant l'une des revendications 3 à 5, dans lequel le revêtement (7) de la deuxième sous-région (5) de la surface (3) est constitué au moins partiellement d'un nitrure métallique.

7. Cristal germe suivant l'une des revendications 3 à 6, dans lequel le revêtement (7) de la deuxième sous-région (5) de la surface (3) est constitué au moins partiellement de tantale (Ta) et/ou d'un composé de tantale.

8. Cristal germe suivant l'une des revendications 3 à 7, dans lequel le revêtement (7) de la deuxième sous-région (5) de la surface (3) est constitué au moins partiellement de molybdène (Mo) et/ou d'un composé de molybdène.

9. Cristal germe suivant l'une des revendications précédentes, dans lequel le revêtement (7) de la deuxième sous-région (5) de la surface (3) est constitué au moins partiellement de carbone.

10. Cristal germe suivant la revendication 9, dans lequel le revêtement (7) de la deuxième sous-région (5) de la surface (3) est constitué au moins partiellement de graphite.

11. Cristal germe suivant l'une des revendications précédentes, dans lequel le revêtement (7) de la deuxième sous-région (5) de la surface (3) comprend plusieurs couches superposées.

12. Cristal germe suivant l'une des revendications précédentes, dans lequel la deuxième sous-région (5) de la surface (3) est disposée sur un côté de la surface (3) qui est éloigné de la première sous-région (4).

13. Cristal germe suivant l'une des revendications précédentes, dans lequel le revêtement (7) a une épaisseur de 100 µm environ au plus.

14. Cristal germe suivant l'une des revendications précédentes, dans lequel le revêtement (7) a une épaisseur de 10 µm environ au plus.

15. Cristal germe suivant l'une des revendications précédentes, ayant une épaisseur mesurée perpendiculairement à la surface de cristallisation d'au moins 0,5 mm.

16. Utilisation d'un cristal germe suivant l'une des revendications précédentes pour la préparation d'un monocristal de carbure de silicium (SiC) dans un processus de sublimation.

17. Utilisation d'un cristal germe suivant l'une des revendications 1 à 15 pour la préparation d'un monocristal de carbure de silicium (SiC) par un dépôt chimique en phase vapeur (CVD).

18. Procédé de préparation d'un monocristal de carbure de silicium comportant les étapes qui consistent en ce que :
a) du carbure de silicium (SiC) sous forme solide est au moins en partie sublimé, et
b) on fait croître, à partir du carbure de silicium sublimé en phase gazeuse, un monocristal de carbure de silicium (6) sur une première région (4) de la surface (3) d'un cristal (2) germe, prévue en tant que surface de cristalisation, à une température au moins égale à une température de croissance prescrite à l'avance,
c) un cristal germe (2) suivant l'une des revendications 1 à 15 étant utilisé.

19. Procédé pour la préparation d'une couche de carbure de silicium monocristallin par dépôt chimique en phase vapeur (CVD), un cristal germe (2) suivant l'une des revendications 1 à 15 étant utilisé comme substrat pour le dépot de la couche de carbure de silicium,
